# EUROPEAN PATENT SPECIFICATION

(11) **EP 1 737 065 B1**
(45) Date of publication and mention of the grant of the patent: **01.11.2017**
(21) Application number: 06010553.3
(22) Date of filing: 22.05.2006
(51) Int. Cl.: H01Q 1/22, H01Q 21/28, H01Q 1/40, H01Q 1/44, H01L 23/66

(54) **WLAN communications module and integrated chip package**
WLAN-Modul und Schaltungschipverpackung
Module WLAN et boitier pour circuit intégré

(30) Priority: 21.06.2005 US 157286
(43) Date of publication of application: 27.12.2006
(73) Proprietor: Marvell World Trade Ltd., St. Michael 14027 (BB)
(72) Inventor: Janofsky, Eric B., Sunnyvale California 94085 (US)
(74) Representative: Grünecker Patent- und Rechtsanwälte PartG mbB

(56) References cited:
- JP-A- H0 879 813
- US-A1- 2002 000 938
- US-A1- 2002 000 938
- US-A1- 2005 088 998
- PATENT ABSTRACTS OF JAPAN vol. 1996, no. 07, 31 July 1996 (1996-07-31) -& JP 08 079813 A (KOKUSAI ELECTRIC CO LTD), 22 March 1996 (1996-03-22)

## Description

### BACKGROUND

The present invention relates generally to devices for wireless communications. More particularly, the present invention relates to a wireless local area network communications module and integrated circuit package.

Published patent application US 2005/088998 A1 discloses a method and an apparatus for cell identification in wireless data networks and suggests to provide a wireless local area network module comprising an antenna to receive first OFDM signals and to transmit second OFDM signals; a communications circuit comprising an OFDM demodulator and an OFDM modulator; a host interface to provide the first digital to a host and to receive the second digital data from the host and a printed circuit board. According to this document, the antenna and the communication circuit are arranged on the printed circuit board.

From JP 08-079813 A a receiver structure is known, comprising an antenna change over switch which is provided between a receiver and a built-in antenna. The antenna change over switch may be used to selectively choose the built-in antenna or an external antenna.

US 2002/0000938 A1 relates to a diversity wireless device which comprises an internal antenna element and a connector for an external antenna and a switch provided within the connector for choosing the external antenna in the case that the external antenna is plugged into the connector. An RF circuit is mounted together with the antennae onto the same substrate.

In general, in one aspect, the invention features a wireless local area network module comprising: an antenna to receive first orthogonal frequency-division multiplexing (OFDM) signals, and to transmit second OFDM signals; a communication circuit comprising an OFDM demodulator to produce first digital data based on the first OFDM signals, and an OFDM modulator to produce the second OFDM signals based on second digital data; a host interface to provide the first digital data to a host, and to receive the second digital data from the host; an external antenna interface to receive the first OFDM signals from, and to transmit the second OFDM signals to, an external antenna; at least one switch to provide a signal path for the first and second OFDM signals between the communication circuit and one of the antenna and the external antenna interface in accordance with a control signal; and a printed circuit board, wherein the antenna, the communication circuit, and the external antenna interface are arranged on the printed circuit board. Some embodiments comprise an integrated circuit comprising the communication circuit and the external antenna interface.

In general, in one aspect, the invention features a wireless local area network module comprising means for receiving first orthogonal frequency-division multiplexing (OFDM) signals, and for transmitting second OFDM signals; means for communicating comprising OFDM demodulator means for producing first digital data based on the first OFDM signals, and OFDM modulator means for producing the second OFDM signals based on second digital data; host interface means for providing the first digital data to a host, and for receiving the second digital data from, the host; external antenna interface means for receiving the first OFDM signals from, and for transmitting the second OFDM signals to, an external antenna; and at least one switch means for providing a signal path for the first and second OFDM signals between the means for communicating and one of the means for receiving and the external antenna interface means in accordance with a control signal. Some embodiments comprise integrated circuit means comprising the means for communicating and the external antenna interface means.

Some embodiments comprise an integrated circuit comprising the communication circuit and the external antenna interface. In some embodiments, the communication circuit comprises: an OFDM demodulator to produce first digital data based on the first OFDM signals, and an OFDM modulator to produce the second OFDM signals based on second digital data. In some embodiments, a wireless local area network module comprises the wireless RF module. In some embodiments the host interface complies with at least one specification selected from the group comprising Peripheral Component Interconnect (PCI); PCI Express; Mini PCI; PC card; Universal Serial Bus; and Firewire. Some embodiments comprise a printed circuit board having the antenna, the communication circuit, and the external antenna interface arranged thereon. a printed circuit board having the antenna mounted thereon. Some embodiments comprise a printed circuit board comprising the antenna, and having the communication circuit and the external antenna interface arranged thereon. Some embodiments comprise a memory to store the control signal. In some embodiments, the communication circuit is compliant with at least one standard selected from the group consisting of IEEE standards 802.11, 802.11a, 802.11b, 802.11g. 802.11n, 802.16, and 802.20.

The details of one or more implementations are set forth in the accompanying drawings and the description below. Other features will be apparent from the description and drawings, and from the claims.

### DESCRIPTION OF DRAWINGS

FIG. 1 shows a WLAN communications module connected to a host such as a personal computer.
FIG. 2 shows a WLAN communications module comprising an external antenna interface for connecting an external antenna according to a preferred embodiment.
FIG 3 shows an integrated circuit package comprising a heat sink comprising an antenna.
FIG 4 shows a method of manufacturing an integrated circuit package comprising a heat sink comprising an antenna.
FIG 5 shows an integrated circuit package comprising an intermediate substrate comprising an antenna.
FIG 6 shows a method of manufacturing an integrated circuit package comprising an intermediate substrate comprising an antenna.
FIG 7 shows an integrated circuit package comprising a package substrate comprising an antenna according to a preferred embodiment.
FIG 8 shows a method of manufacturing an integrated circuit package comprising a package substrate comprising an antenna according to a preferred embodiment.
FIG 9 shows an integrated circuit package comprising a case comprising an antenna.
FIG 10 shows a method of manufacturing an integrated circuit package comprising a case comprising an antenna.

The leading digit(s) of each reference numeral used in this specification indicates the number of the drawing in which the reference numeral first appears.

### DETAILED DESCRIPTION

Embodiments of the present invention comprise a wireless local-area network (WLAN) communications module such as an orthogonal frequency-division multiplexing (OFDM) communications module comprising a host interface. The module can be fabricated, for example, as a PC card for use with a laptop computer. Other embodiments of the module employ other implementations.

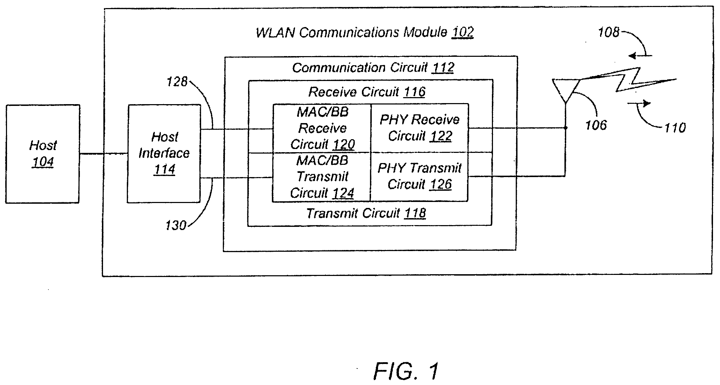

FIG. 1 shows a WLAN communications module 102 connected to a host 104 such as a personal computer according to a preferred embodiment. Module 102 comprises an antenna 106 to receive radio-frequency (RF) signals 108 and to transmit RF signals 110, a communication circuit 112, and a host interface 114 to communicate with host 104, which are preferably arranged on a printed circuit board.

Communication circuit 112 comprises a receive circuit 116 to produce digital data 128 based on RF signals 108, and a transmit circuit 118 to produce RF signals 110 based on digital data 130 received from host 104 over host interface 114. Communication circuit 112 provides digital data 128 to host 104 over host interface 114. Receive circuit 116 preferably comprises a media access controller and baseband (MAC/BB) receive circuit 120 and a physical-layer device (PHY) receive circuit 122 that operate according to well-known techniques. Transmit circuit 118 preferahly comprises a MAC/BB transmit circuit 124 and a PHY transmit circuit 126 that operate according to well-known techniques. In some embodiments, module 102 is compliant with one or more of IEEE standards 802.11, 802.11a, 802.11b, 802.11g. 802.11n, 802.16, and 802.20, other regional and national standards, and the like. In some embodiments, the communication circuit comprises an OFDM demodulator and an OFDM modulator for use in a wireless LAN.

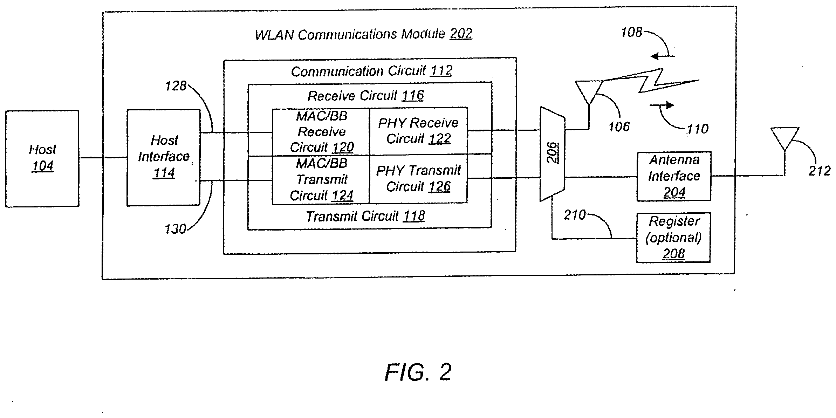

FIG. 2 shows a WLAN communications module 202 comprising an external antenna interface 204 for connecting an external antenna according to a preferred embodiment. Elements 106-130 of module 202 are as described above for communications module 102 of FIG. 1. However, module 202 also includes external antenna interface 204, a switch 206 and an optional memory such as a register 208. External antenna interface 204 can be implemented as a connector that allows an external antenna 212 to be connected to module 202. Switch 206 provides a signal path for RF signals 108, 110 between communication circuit 112 and either antenna 106 or external antenna interface 204 in accordance with a control signal 210. Control signal 210 can be generated in any number of ways. For example, control signal 210 can be provided directly to switch 206 by host 104 over host interface 114, can be stored as a flag in optional register 208, or can be provided by antenna interface 204 on detecting an external antenna 212. In some embodiments, module 202 is compliant with one or more of IEEE standards 802.11, 802.11a, 802.11b, 802.11g, 802.11n, 802.1.6, and 802.20, other regional and national standards, and the like.

In some embodiments, host interface 114 complies with at least one specification selected from the group comprising complies with at least one specification selected from the group comprising Peripheral Component Interconnect (PCI); PCI Express; Mini PCI; PC card; Universal Serial Bus; and Firewire. Other embodiments employ other specifications for host interface 114.

Embodiments of the present invention comprise an integrated circuit package and method for forming the same, where the integrated circuit package comprises an antenna and at least one integrated circuit preferably implemented in a flip chip ball grid array (FCBGA). In a FCBGA, the integrated circuit is generally connected to a package substrate via solder balls. The package substrate is coupled to the circuit board through solder balls on the underside of the package. Embodiments of the integrated circuit package can be used in embodiments of the communications module to house the communication circuit therein.

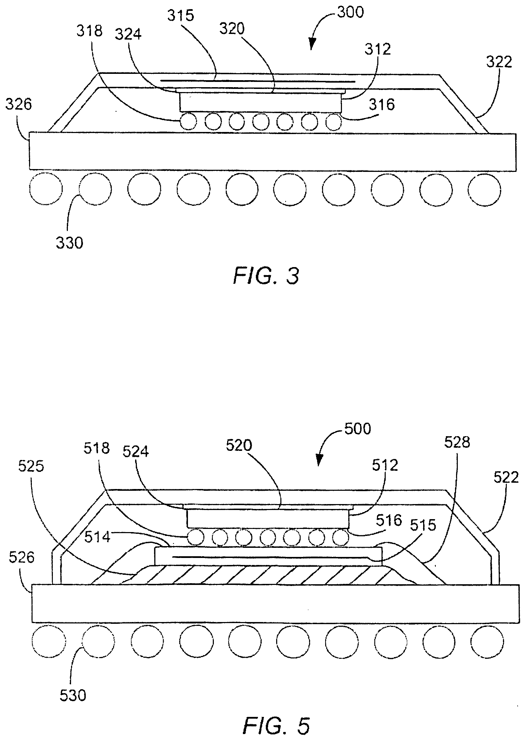

FIG 3 shows an integrated circuit package 300 comprising a heat sink 322 comprising an antenna 315. Integrated circuit package 300 is preferably a FCBGA that can dissipate heat through heat sink 322. In addition, the thermal path of integrated circuit package 300 extends away from the circuit board to reduce the heat load on the circuit board. But while embodiments of the present invention are described in terms of FCBGAs, embodiments of the present invention are not limited to FCBGAs, and can be implemented using any other integrated circuit packaging technologies which currently exist or are under development.

Heat sink 322 comprises one or more antennas 315, which can be attached on a surface of heat sink 122 or formed within heat sink 122. In some arrangements, heat sink 315 is an antenna. To accommodate size restrictions imposed by the size of heat sink 322, antenna 315 can have a length that is a vulgar fraction of a wavelength of the signals transmitted and received by antenna 315. A vulgar fraction consists of one integer divided by a non-zero integer, as is well-known in the relevant arts.

Integrated circuit package 300 includes a integrated circuit 312 configured for flip chip mounting. Integrated circuit 312 preferably comprises communications circuits for transmitting and/or receiving data over antenna 315. For example, integrated circuit 312 can comprise a communication circuit comprising a receive circuit to produce first digital data based on first RF signals received by antenna 315, and a transmit circuit to produce second RF signals based on second digital data, wherein the second RF signals are transmitted by antenna 315. The communications circuit can comprise a media access controller/baseband circuit (MAC/BB) and a physical-layer device (PHY) that is electrically connected to antenna 315. The communication circuit is preferably compliant with one or more of IEEE standards 802.11, 802.11a, 802.11b, 802.11g, 302.11n, 802.16, and 802.20, other regional and national standards, and the like. In some embodiments, the communication circuit comprises an OFDM demodulator and an OFDM modulator for use in a wireless LAN.

A first surface 316 of the integrated circuit 312 is electrically connected to the package substrate 326 via conductive bumps 318. The conductive bumps 318 may be formed from any electrically conductive material such as Pb/Sn solder, Au, Ag, alloys of Au and Ag, and metallic coated polymeric studs. In addition, an epoxy or other suitable material formed between the conductive bumps 318 may be used as an embedding material for the conductive bumps 318 to provide mechanical support and moisture protection. The integrated circuit 312 may be attached to the package substrate 326 using any flip chip compatible bonding method such as thermocompression, soldering, encapsulation, and adhesives.

The other surface 320 of the integrated circuit 312 is attached to a heat sink 322 for coupling heat away from the integrated circuit 312. The heat sink 322 may be made of any thermally conductive material such as copper and thermally conductive plastic. The integrated circuit 312 may be attached to the heat sink 322 by any attachment item 324 that does not thermally isolate the integrated circuit 312 such as adhesive, solder, and press-fitting by applying a mechanical force to the first surface of the integrated circuit 312 or the package substrate 326. For example, a thermally conductive epoxy may be used as the attachment item 324.

Package substrate 326 may be made of any substrate material suitable for ball grid array mounting to a device such as a circuit board or substrate. A plurality of conductive bumps 330 are provided for connecting integrated circuit package 300 to a circuit board or the like.

The number of integrated circuits 312 in integrated circuit package 300 according to embodiments of the present invention is not limited to one. Any practical number of integrated circuits 312 can be implemented within a single integrated circuit package 300 to form a multichip module (MCM). For example, an integrated circuit package 300 can include two integrated circuits 312 where one of the integrated circuits 312 comprises a MAC/BB and the other comprises a PHY.

FIG 4 shows a method 400 of manufacturing an integrated circuit package 300 comprising a heat sink 322 comprising an antenna 315. Method 400 comprises providing at least one integrated circuit 312 having a conductor pattern on a first surface, wherein integrated circuit 312 comprises a wireless communication circuit (step 402), electrically coupling the conductor pattern on integrated circuit 312 to a package substrate 326 via a set of conductive bumps 318 (step 404), providing a heat sink 322 comprising an antenna 315 (step 406), electrically coupling antenna 315 to the wireless communication circuit (step 408), and thermally coupling a second surface 320 of integrated circuit 312 to heat sink 322 (step 410).

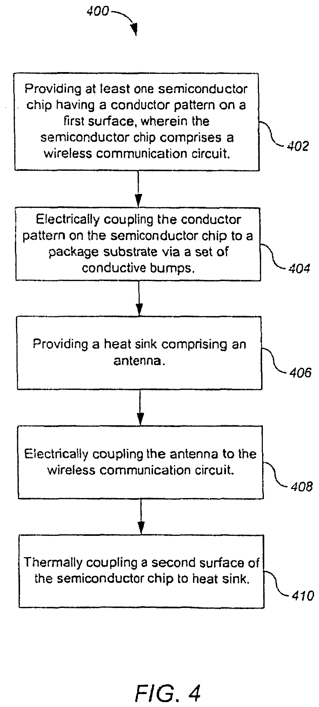

FIG. 5 shows an integrated circuit package 500 comprising an intermediate substrate 514 comprising an antenna 515. Integrated circuit package 510 is preferably a modified FCBGA that can optionally dissipate approximately the same amount of heat as a conventional flip chip package at a much lower cost with the addition of optional heat sink 522. In addition, the thermal path of integrated circuit package 500 extends away from the circuit board to reduce the heat load on the circuit board. But while embodiments of the present invention are described in terms of FCBGAs, embodiments of the present invention are not limited to FCBGAs, and can be implemented using any other integrated circuit packaging technologies which currently exist or are under development.

Integrated circuit package 500 includes a integrated circuit 512 configured for flip chip mounting that is attached to an intermediate substrate 514 that comprises one or more antennas 515 that can be formed, for example, by etching intermediate substrate 514. To accommodate size restrictions imposed by the size of intermediate substrate 514, antenna 515 can have a length that is a vulgar fraction of a wavelength of the signals transmitted and received by antenna 515.

Integrated circuit 512 preferably comprises communications circuits for transmitting and/or receiving data over antenna 515. For example, integrated circuit 512 can comprise a communication circuit comprising a receive circuit to produce first digital data based on first RF signals received by antenna 515, and a transmit circuit to produce second RF signals based on second digital data, wherein the second RF signals are transmitted by antenna 515. The communications circuit can comprise a media access controller and baseband (MAC/BB) and a physical-layer device (PHY) that is electrically connected to antenna 515. The communication circuit is preferably compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

A first surface 516 of the integrated circuit 512 is electrically connected to the intermediate substrate 514 via conductive bumps 518. The conductive bumps 518 may be formed from any electrically conductive material such as Pb/Sn solder, Au, Ag, alloys of Au and Ag, and metallic coated polymeric studs. In addition, an epoxy or other suitable material formed between the conductive bumps 518 may be used as an embedding material for the conductive bumps 518 to provide mechanical support and moisture protection. The integrated circuit 512 may be attached to the intermediate substrate 514 using any flip chip compatible bonding method such as thermocompression, soldering, encapsulation, and adhesives.

The other surface 520 of the integrated circuit 512 is attached to an optional heat sink 522 for coupling heat away from the integrated circuit 512. The heat sink 522 may be made of any thermally conductive material such as copper and thermally conductive plastic. The integrated circuit 512 may be attached to the heat sink 522 by any attachment item 524 that does not thermally isolate the integrated circuit 512 such as adhesive, solder, and press-fitting by applying a mechanical force to the first surface of the integrated circuit 512 or the intermediate substrate 514. For example, a thermally conductive epoxy may be used as the attachment item 524.

The intermediate substrate 514 is electrically connected to conductors on a package substrate 526 via several bonding wires 528. The intermediate substrate 514 converts flip chip mounting of the integrated circuit 512 into wire bond mounting to combine and exceled the advantages of FCBGA and PBGA. Similar to FCBGA, the integrated circuit package 500 provides a low resistance thermal path for heat generated in the integrated circuit 512 so that power dissipation may be accommodated. In addition, the thermal path of the integrated circuit package 500 extends to the heat sink 522, away from the package substrate 526, thereby reducing the heat load of the circuit board or circuit substrate to which the integrated circuit package 500 is connected. Also, the integrated circuit package may employ a substrate that is as inexpensive as substrates used for PBGA packages. Additionally, using the intermediate substrate 514 reduces the wiring pitch requirements on bonding wire equipment used for attaching the bonding wires 528.

Package substrate 526 may be made of any substrate material suitable for ball grid array mounting to a device such as a circuit board or substrate. Additionally, a support layer 525 such as an epoxy or other suitable material may be inserted between intermediate substrate 514 and package substrate 526 to provide addition mechanical support. A plurality of conductive bumps 530 are provided for connecting integrated circuit package 500 to a circuit board or the like.

The number of integrated circuits 512 in integrated circuit package 500 is not limited to one. Any practical number of integrated circuits 512 can be implemented within a single integrated circuit package 500 to form a multichip module (MCM). For example, an integrated circuit package 500 can include two integrated circuits 512 where one of the integrated circuits 512 comprises a MAGBB and the other comprises a PHY. Furthermore, while embodiments of the present invention are described in terms of FCBGAs, other embodiments are not limited to FCBGAs, and can be implemented using any other integrated circuit packaging technologies which currently exist or are under development.

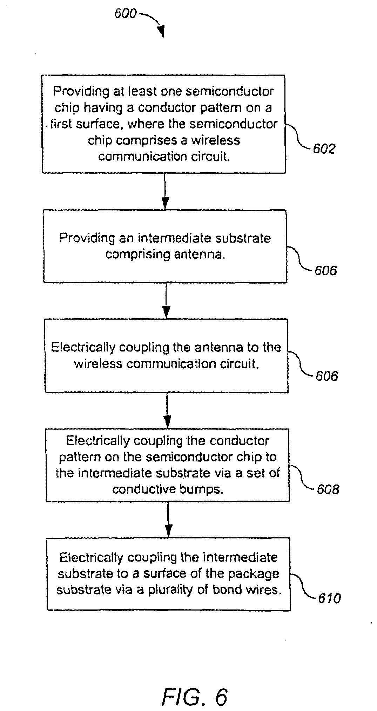

FIG 6 shows a method 600 of manufacturing an integrated circuit package 500 comprising an intermediate substrate 514 comprising an antenna 515. Method 600 comprises providing at least one integrated circuit 512 having a conductor pattern on a first surface, wherein integrated circuit 512 comprises a wireless communication circuit (step 602), providing an intermediate substrate 514 comprising an antenna 515 (step 604), electrically coupling antenna 515 to the wireless communication circuit (step 606), electrically coupling the conductor pattern on integrated circuit 512 to intermediate substrate 514 via a set of conductive bumps 518 (step 608), and electrically coupling intermediate substrate 514 to a surface of package substrate 526 via a plurality of bond wires 528 (step 610).

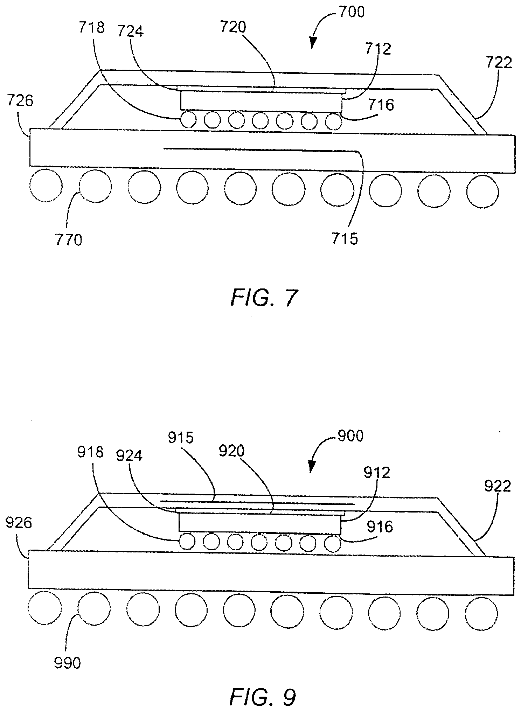

FIG 7 shows an integrated circuit package 700 comprising a package substrate 726 comprising an antenna 715 according to a preferred embodiment. Integrated circuit package 700 is preferably a FCBGA. But while embodiments of the present invention are described in terms of FCBGAs, embodiments of the present invention are not limited to FCBGAs, and can be implemented using any other integrated circuit packaging technologies which currently exist or are under development.

Package substrate 726 comprises one or more antennas 715, which can be attached on a surface of package substrate 726 or formed within package substrate 726. To accommodate size restrictions imposed by the size of package substrate 726, antenna 715 can have a length that is a vulgar fraction of a wavelength of the signals transmitted and received by antenna 715. A vulgar fraction consists of one integer divided by a non-zero integer, as is well-known in the relevant arts.

Integrated circuit package 700 includes a integrated circuit 712 configured for flip chip mounting. Integrated circuit 712 preferably comprises communications circuits for transmitting and/or receiving data over antenna 715. For example, integrated circuit 712 can comprise a communication circuit comprising a receive circuit to produce first digital data based on first RF signals received by antenna 715, and a transmit circuit to produce second RF signals based on second digital data, wherein the second RF signals are transmitted by antenna 715. The communications circuit can comprise a media access controller/baseband circuit (MAC/BB) and a physical-layer device (PHY) that is electrically connected to antenna 715. The communication circuit is preferably compliant with one or more of IEEE standards 802.11, 802.11a, 802.11b, 802.11g. 802.1 In, 802.16, and 802.20, other regional and national standards, and the like. In some embodiments, the communication circuit comprises an OFDM demodulator and an OFDM modulator for use in a wireless LAN.

A first surface 716 of the integrated circuit 712 is electrically connected to the package substrate 726 via conductive bumps 718. The conductive bumps 718 may be formed from any electrically conductive material such as Pb/Sn solder, Au, Ag, alloys of Au and Ag, and metallic coated polymeric studs. In addition, an epoxy or other suitable material formed between the conductive bumps 718 may be used as an embedding material for the conductive bumps 718 to provide mechanical support and moisture protection. The integrated circuit 712 may be attached to the package substrate 726 using any flip chip compatible bonding method such as thermocompression, soldering, encapsulation, and adhesives.

The other surface 720 of the integrated circuit 712 is optionally attached to a heat sink 722 for coupling heat away from the integrated circuit 712. Optional heat sink 722 may be made of any thermally conductive material such as copper and thermally conductive plastic. The integrated circuit 712 may be attached to the heat sink 722 by any attachment item 724 that does not thermally isolate the integrated circuit 712 such as adhesive, solder, and press-fitting by applying a mechanical force to the first surface of the integrated circuit 712 or the package substrate 726. For example, a thermally conductive epoxy may be used as the attachment item 724.

Package substrate 726 may be made of any substrate material suitable for ball grid array mounting to a device such as a circuit board or substrate. A plurality of conductive bumps 730 are provided for connecting integrated circuit package 700 to a circuit board or the like.

The number of integrated circuits 712 in integrated circuit package 700 according to embodiments of the present invention is not limited to one. Any practical number of integrated circuits 712 can be implemented within a single integrated circuit package 700 to form a multichip module (MCM). For example, an integrated circuit package 700 can include two integrated circuits 712 where one of the integrated circuits 712 comprises a MAC/BB and the other comprises a PHY

FIG 8 shows a method 800 of manufacturing an integrated circuit package 700 comprising a package substrate 726 comprising an antenna 715 according to a preferred embodiment. Method 800 comprises providing at least one integrated circuit 712 having a conductor pattern on a first surface, wherein integrated circuit 712 comprises a wireless communication circuit (step 802), electrically coupling the conductor pattern on integrated circuit 712 to a package substrate 726 comprising an antenna 715 via a set of conductive bumps 718 (step 804), providing optional heat sink 722 (step 806), electrically coupling antenna 715 to the wireless communication circuit (step 808), and optionally thermally coupling a second surface 720 of integrated circuit 712 to optional heat sink 722 (step 810).

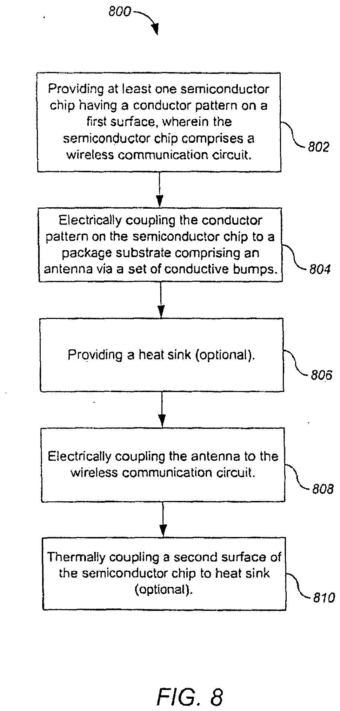

FIG 9 shows an integrated circuit package 900 comprising a case 922 comprising an antenna 915. Case 922 can be made of plastic, ceramic, or any other material, as is well-known in the relevant arts. Integrated circuit package 900 is preferably a FCBGA. But while embodiments of the present invention are described in terms of FCBGAs, embodiments of the present invention are not limited to FCBGAs, and can be implemented using any other integrated circuit packaging technologies which currently exist or are under development.

Case 922 comprises one or more antennas 915, which can be attached on a surface of case 122 or formed within case 122. To accommodate size restrictions imposed by the size of case 922, antenna 915 can have a length that is a vulgar fraction of a wavelength of the signals transmitted and received by antenna 915. A vulgar fraction consists of one integer divided by a non-zero integer, as is well-known in the relevant arts.

Integrated circuit package 900 includes a integrated circuit 912 configured for flip chip mounting. Integrated circuit 912 preferably comprises communications circuits for transmitting and/or receiving data over antenna 915. For example, integrated circuit 912 can comprise a communication circuit comprising a receive circuit to produce first digital data based on first RF signals received by antenna 915, and a transmit circuit to produce second RF signals based on second digital data, wherein the second RF signals are transmitted by antenna 915. The communications circuit can comprise a media access controller/baseband circuit (MAC/BB) and a physical-layer device (PHY) that is electrically connected to antenna 915. The communication circuit is preferably compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

A first surface 916 of the integrated circuit 912 is electrically connected to the package substrate 926 via conductive bumps 918. The conductive bumps 918 may be formed from any electrically conductive material such as Pb/Sn solder, Au, Ag, alloys of Au and Ag, and metallic coated polymeric studs. In addition, an epoxy or other suitable material formed between the conductive bumps 918 may be used as an embedding material for the conductive bumps 918 to provide mechanical support and moisture protection. The integrated circuit 912 may be attached to the package substrate 926 using any flip chip compatible bonding method such as thermocompression, soldering, encapsulation, and adhesives. Antenna 915 can be electrically coupled to integrated circuit 912 by conductive bumps 918, by other conventional types of interconnects, or by a special-purpose interconnect provided especially for antenna 915.

Package substrate 926 may be made of any substrate material suitable for ball grid array mounting to a device such as a circuit board or substrate. A plurality of conductive bumps 930 are provided for connecting integrated circuit package 900 to a circuit board or the like.

The number of integrated circuits 912 in integrated circuit package 900 according to embodiments of the present invention is not limited to one. Any practical number of integrated circuits 912 can be implemented within a single integrated circuit package 900 to form a multichip module (MCM). For example, an integrated circuit package 900 can include two integrated circuits 912 where one of the integrated circuits 912 comprises a MAC/BB and the other comprises a PHY.

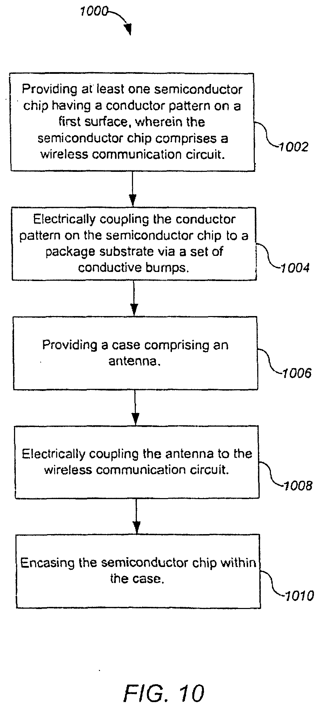

FIG. 10 shows a method 1000 of manufacturing an integrated circuit package 900 comprising a case 922 comprising an antenna 915 . Method 1000 comprises providing at least one integrated circuit 912 having a conductor pattern on a first surface, wherein integrated circuit 912 comprises a wireless communication circuit (step 1002), electrically coupling the conductor pattern on integrated circuit 912 to a package substrate 926 via a set of conductive bumps 918 (step 1004), providing a case 922 comprising an antenna 915 (step 1006), electrically coupling antenna 915 to the wireless communication circuit (step 1008), and encasing integrated circuit 912 within case 922 (step 1010).

## Claims

1. A wireless local area network module (102) comprising:
an antenna (106) to receive first orthogonal frequency-division multiplexing, OFDM, signals, and to transmit second OFDM signals;
a communication circuit (112) comprising
an OFDM demodulator to produce first digital data based on the first OFDM signals, and
an OFDM modulator to produce the second OFDM signals based on second digital data;
a host interface (114) to provide the first digital data to a host (104), and to receive the second digital data from the host;
an external antenna interface (204) to receive the first OFDM signals from, and to transmit the second OFDM signals to, an external antenna (212); and
a printed circuit board,
**characterized in** further comprising:
at least one switch (206) to provide a signal path for the first and second OFDM signals between the communication circuit and one of the antenna and the external antenna interface in accordance with a control signal;
wherein the antenna is formed within the printed circuit board, and wherein the communication circuit and the external antenna interface are arranged on the printed circuit board.

2. The wireless local area network module of claim 1, further comprising:
an integrated circuit comprising the communication circuit and the external antenna interface.

3. The wireless local area network module of claim 1, wherein the host interface complies with at least one specification selected from the group comprising:
Peripheral Component Interconnect (PCI);
PCI Express;
Mini PCI;
PC card;
Universal Serial Bus; and
Firewire.

4. The wireless local area network module of claim 1, further comprising:
a memory to store the control signal.

5. The wireless local area network module of claim 1, wherein the communication circuit is compliant with at least one standard selected from the group consisting of IEEE standards 802.11, 802.11a, 802.11b, 802.11g, 802.11n, 802.16, and 802.20.

## Patentansprüche

1. Drahtloses lokales Netzwerkmodul (102), umfassend:
eine Antenne (106) zum Empfangen von ersten OFDM-Signalen (Orthogonal Frequency-Division Multiplexing) und zum Senden von zweiten OFDM-Signalen;
eine Kommunikationsschaltung (112), die umfasst:
einen OFDM-Demodulator zum Erzeugen von ersten digitalen Daten basierend auf den ersten OFDM-Signalen, und
einen OFDM-Modulator zum Erzeugen der zweiten OFDM-Signale basierend auf zweiten digitalen Daten;
eine Host-Schnittstelle (114) zum Bereitstellen der ersten digitalen Daten für einen Host (104) und zum Empfangen der zweiten digitalen Daten von dem Host;
eine externe Antennenschnittstelle (204), um die ersten OFDM-Signale von einer externen Antenne (212) zu empfangen und die zweiten OFDM-Signale an diese zu senden; und
eine gedruckte Schaltung,
**dadurch gekennzeichnet, dass** es des Weiteren umfasst:
mindestens einen Schalter (206) zum Bereitstellen eines Signalweges für die ersten und zweiten OFDM-Signale zwischen der Kommunikationsschaltung und einem aus der Antenne und der externen Antennenschnittstelle entsprechend einem Steuersignal;
wobei die Antenne in der gedruckten Schaltung ausgebildet ist und wobei die Kommunikationsschaltung und die externe Antennenschnittstelle auf der gedruckten Schaltung angeordnet sind.

2. Drahtloses lokales Netzwerkmodul nach Anspruch 1, des Weiteren umfassend:
eine integrierte Schaltung, umfassend die Kommunikationsschaltung und die externe Antennenschnittstelle.

3. Drahtloses lokales Netzwerkmodul nach Anspruch 1, wobei die Host-Schnittstelle mindestens eine Spezifikation erfüllt, die aus der Gruppe gewählt wird, welche umfasst:
PCI (Peripheral Component Interconnect);
PCI Express;
Mini PCI;
PC-Karte;
USB; und
Firewire.

4. Drahtloses lokales Netzwerkmodul nach Anspruch 1, des Weiteren umfassend:
einen Speicher zum Speichern des Steuersignals.

5. Drahtloses lokales Netzwerkmodul nach Anspruch 1, wobei die Kommunikationsschaltung mindestens einen Standard erfüllt, der aus der Gruppe gewählt wird, die aus den IEEE-Standards 802.11, 802.11a, 802.11b, 802.11g, 802.11n, 802.16 und 802.20 besteht.

## Revendications

1. Module de réseau local sans fil (102) comprenant:
une antenne (106) pour recevoir les premiers signaux de multiplexage par division de fréquence orthogonale, OFDM, et pour transmettre des seconds signaux OFDM;
un circuit de communication (112) comprenant
un démodulateur OFDM pour produire des premières données numériques sur la base des premiers signaux OFDM, et
un modulateur OFDM pour produire les seconds signaux OFDM sur la base de secondes données numériques;
une interface hôte (114) pour fournir les premières données numériques à un hôte (104), et pour recevoir les secondes données numériques à partir de l'hôte;
une interface d'antenne externe (204) pour recevoir les premiers signaux OFDM depuis une antenne externe (212) et pour transmettre les seconds signaux OFDM à celle-ci; et
une carte de circuit imprimé, **caractérisé en ce que** le module comprendre en outre:
au moins un commutateur (206) pour fournir un trajet de signal pour les premiers signaux OFDM et les seconds signaux OFDM entre le circuit de communication et une de l'antenne et l'interface d'antenne externe en fonction d'un signal de commande;
dans lequel l'antenne est formée à l'intérieur de la carte de circuit imprimé, et dans lequel le circuit de communication et l'interface d'antenne externe sont agencés sur la carte de circuit imprimé.

2. Module de réseau local sans fil selon la revendication 1, comprenant en outre:
un circuit intégré comprenant le circuit de communication et l'interface d'antenne externe.

3. Module de réseau local sans fil selon la revendication 1, dans lequel l'interface hôte est conforme à au moins une spécification choisie dans le groupe comprenant:
Peripheral Component Interconnect (PCI);
PCI Express;
Mini PCI;
Carte PC;
Bus série universel;
Firewire.

4. Module de réseau local sans fil selon la revendication 1, comprenant en outre:
une mémoire pour stocker le signal de commande.

5. Module de réseau local sans fil selon la revendication 1, dans lequel le circuit de communication est conforme à au moins une norme choisie dans le groupe constitué par les normes IEEE 802.11, 802.11a, 802.11b, 802.11g, 802.11n, 802.16 et 802.20.
